# EUROPEAN PATENT APPLICATION

(11) **EP 3 422 426 A1**
(43) Date of publication of application: **02.01.2019**
(21) Application number: 17178082.8
(22) Date of filing: 27.06.2017
(51) Int. Cl.: H01L 33/62, H01L 33/48

(54) **LED DEVICE AND A METHOD OF MANUFACTURING THE LED DEVICE**

(71) Applicant: Lumileds Holding B.V., 1118 BG Schiphol (NL)
(72) Inventor: The designation of the inventor has not yet been filed
(74) Representative: Rüber, Bernhard Jakob

(57) **Abstract**

A LED device and a method of manufacturing the LED device are provided. The LED device comprises a mounting board (100), at least one LED chip (200) mounted on a top surface of the mounting board (100), and an overmolded leadframe (300) soldered or attached to a bottom surface of the mounting board (100). The at least one LED chip (200) is electrically connected to the overmolded leadframe (300) through via electrodes (1031, 1032) formed in the mounting board (100).

## Description

### TECHNICAL FIELD

The present application relates to a light emitting diode (LED) device and a method of manufacturing the LED device.

### BACKGROUND

LEDs may allow a material included therein to emit light using electric energy, and may convert energy generated by a recombination of electrons and holes of bonded semiconductors into light and emit the light. Such LEDs are being widely used as light sources of lighting devices and display devices, and the development of LEDs is gradually accelerating.

Recently, most of LED devices is manufactured by mounting LED chip(s) directly on a leadframe, and then molding the leadframe having the LED chips mounted thereon. The molded leadframe having the LED chips mounted thereon can then e.g. be attached to a PCB. However, the LED chips mounted on the leadframe may be damaged during the molding process.

### SUMMARY

The exemplary embodiments of the inventive concept provide a LED device manufactured by using a mounting board and an overmolded leadframe, that is, the process of mounting LED chips and the process of overmolding leadframes are separated, and do not have a sequential relationship.

According to the invention, there is provided an LED device which may include: a mounting board; at least one LED chip mounted on a top surface of the mounting board; and an overmolded leadframe soldered or attached to a bottom surface of the mounting board. The at least one LED chip is electrically connected to the overmolded leadframe through via electrodes formed in the mounting board.

According to an exemplary embodiment, the at least one LED chip may be mounted in a flip-chip form.

According to an exemplary embodiment, the overmolded leadframe may be attached to the mounting board by conductive adhesive.

According to an exemplary embodiment, a portion of the bottom surface of the mounting board may be covered with copper.

According to an exemplary embodiment, the mounting board may be a FR4 copper clad laminate board.

According to an exemplary embodiment, the at least one LED chip may be a Wafer Level Package.

According to the invention, there is provided a method of manufacturing the inventive LED device comprising: preparing the mounting board with the via electrodes formed therein; mounting the at least one LED chip on the top surface of the mounting board; overmolding a leadframe to form the overmolded leadframe; and soldering or attaching the mounting board having the at least one LED chip mounted thereon to the overmolded leadframe. In that, the at least one LED chip is electrically connected to the overmolded leadframe through the via electrodes formed in the mounting board.

According to the exemplary embodiments of the inventive concept, the process of mounting LED chips and the process of overmolding leadframes are separated, and can be performed in parallel, thus the LED chips are protected from being damaged during the process of overmolding, and the overall process for manufacturing the LED device is simplified. Further, the mounting board provided for mounting the LED chips is interposed between the LED chips mounted thereon and the overmolded leadframe attached thereto, thus the mounting board may absorb thermal expansion stress and can be considered as a buffer layer between two coefficient of thermal expansion (CTE) mismatched components, i.e., the LED chips and the leadframe. Thus, reliability of the LED device having the mounting board is improved.

### BRIEF DESCRIPTION OF THE DRAWINGS

The above and other aspects, features, and advantages of the exemplary embodiments will be more clearly understood from the following detailed description taken in conjunction with the accompanying drawings, in which:
- FIG. 1: is a side cross-sectional view illustrating a LED device according to an exemplary embodiment of the inventive concept;
- FIG. 2: is a side cross-sectional view illustrating a LED chip that can be applied to the LED device according to exemplary embodiments of the inventive concept;
- FIG. 3: is a cross-sectional view illustrating the LED chip shown in FIG. 2 being mounted on a mounting board according to an exemplary embodiment; and
- FIG. 4: is a view illustrating a method of manufacturing a LED device according to an exemplary embodiment of the inventive concept.

### DETAILED DESCRIPTION

Hereinafter, exemplary embodiments of the inventive concept will be described as follows with reference to the attached drawings.

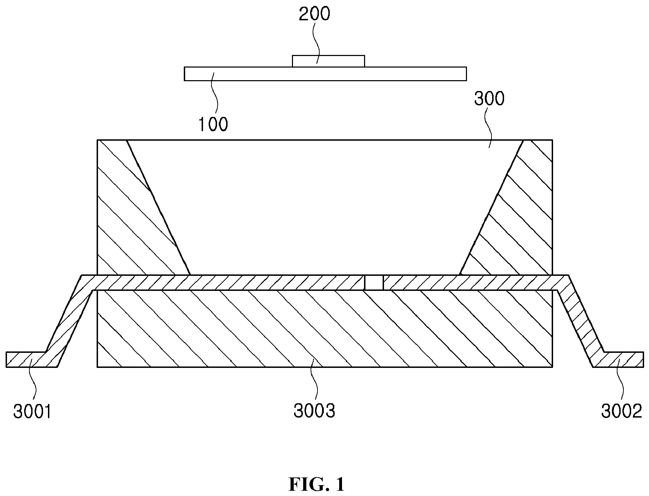

FIG. 1 is a side cross-sectional view illustrating a LED device according to an exemplary embodiment of the inventive concept.

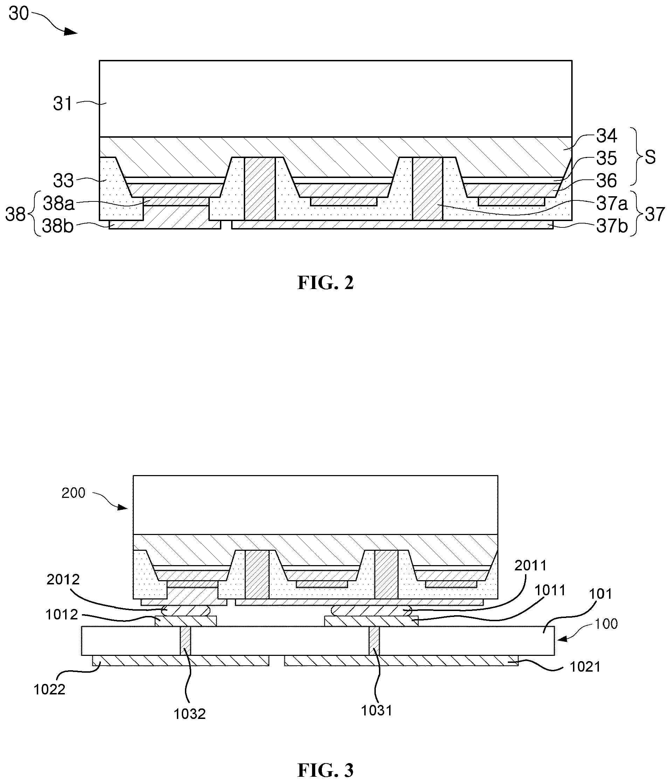

Referring to FIG. 1, a LED device according to an exemplary embodiment may include a mounting board 100, at least one LED chip 200 mounted on a top surface of the mounting board 100, and an overmolded leadframe 300 soldered or attached to a bottom surface of the mounting board 100. For ease of description, the mounting board 100 having the LED chip 200 mounted thereon is shown as being separated from the overmolded leadframe 300, but in fact, the at least one LED chip 200 is electrically connected to the overmolded leadframe 300 through via electrodes (as shown in FIG. 3) formed in the mounting board 100.

According to an exemplary embodiment, the overmolded leadframe 300 may include a body 3003, a first leadframe 3001 and a second leadframe 3002. The overmolded leadframe 300 is prepared before or after mounting the LED chip 200 on the mounting board 100. Alternatively, the process of mounting the LED chip 200 on the mounting board 100 and the process of overmolding the first and second leadframes 3001 and 3002 to form the overmolded leadframe 300 may be performed at substantially the same time. That is to say, according to the present inventive concept, the process of mounting LED chips and the process of overmolding leadframes are separated, and can be performed in parallel, thus the LED chips are protected from being damaged during the process of overmolding, and the overall process for manufacturing the LED device is simplified.

Although Fig. 1 shows only one LED chip 200 being mounted on the mounting board 100, the number of LED chips 200 is not limited thereto. Two or more LED chips 200 may be mounted on the mounting board 100, as desired.

Although Fig. 1 shows the body 3003 being formed to have a cup-shaped upper portion, the invention is not limited thereto. The body 3003 may have any structure as desired.

FIG. 2 is a side cross-sectional view illustrating a LED chip that can be applied to the LED device according to exemplary embodiments of the inventive concept. Referring to FIG. 2, a LED chip 30 includes a semiconductor stacked body S disposed on one surface of a light-transmissive substrate 31. The semiconductor stacked body S may include a first conductivity-type semiconductor layer 34, an active layer 35, and a second conductivity-type semiconductor layer 36.

The LED chip 30 includes first and second electrodes 37 and 38 respectively connected to the first and second conductivity-type semiconductor layers 34 and 36. The first electrode 37 may include a connection electrode portion 37a such as a conductive via connected to the first conductivity-type semiconductor layer 34 through the second conductivity-type semiconductor layer 36 and the active layer 35, and a first electrode pad 37b connected to the connection electrode portion 37a.

The connection electrode portion 37a is surrounded by an insulating portion 33 to be electrically separated from the active layer 35 and the second conductivity-type semiconductor layer 36. The connection electrode portion 37a may be disposed in a region from which the semiconductor stacked body S has been etched. The number and shape of the connection electrode portion 37a, a pitch between adjacent connection electrode portions 37a, and a contact resistance of the connection electrode portion 37a with respect to the first conductivity-type semiconductor layer 34 may be appropriately designed in such a manner that the contact resistance is reduced. Also, the connection electrode portions 37a may be arranged in rows and columns on the semiconductor stacked body S to improve current flow. The second electrode 38 may include an ohmic contact layer 38a and a second electrode pad 38b on the second conductivity-type semiconductor layer 36.

The connection electrode portion 37a and the ohmic contact layer 38a may respectively include a conductive material having ohmic characteristics with respect to the first and second conductivity-type semiconductor layers 34 and 36, and may have a monolayer or a multilayer structure. For example, the connection electrode portion 37a and the ohmic contact layer 38a may include one or more of materials such as silver (Ag), aluminum (Al), nickel (Ni), chromium (Cr), and a transparent conductive oxide (TCO) through a process such as deposition or sputtering.

The first and second electrode pads 37b and 38b may be respectively connected to the connection electrode portion 37a and the ohmic contact layer 38a to serve as external terminals of the LED chip 30. For example, the first and second electrode pads 37b and 38b may include Au, Ag, Al, Ti, W, Cu, Sn, Ni, Pt, Cr, NiSn, TiW, AuSn, or an eutectic metal thereof.

The first and second electrodes 37 and 38 may be disposed in the same direction, and the first and second electrodes 37 and 38 may be mounted in a so-called flip-chip bonding manner on the mounting board 100.

The first and second electrodes 37 and 38 may be electrically separated by an insulating portion 33. The insulating portion 33 may include a material having electrical insulating properties. For example, an insulating material having low light absorption may be used. For example, the insulating portion 33 may include a silicon oxide or a silicon nitride such as SiO₂, SiOₓN_{y}, or SiₓN_{y}.

In an exemplary embodiment, the insulating portion 33 may have a light reflective structure in which a light reflective filler is dispersed in a translucent material. Alternatively, at least a portion of the insulating layer 33 may have a distributed Bragg reflector (DBR) structure in which a plurality of dielectric films having different refractive indices are alternately stacked.

FIG. 3 is a cross-sectional view illustrating the LED chip shown in FIG. 2 being mounted on a mounting board according to an exemplary embodiment. As shown in FIG. 3, the LED chip shown in FIG. 2 is shown as the LED chip 200, but is not limited thereto. Other LED chips may be used as the LED chip 200 shown in FIG. 3.

Referring to FIG. 3, the LED chip 200 is mounted on the mounting board 100 in a flip-chip form. The mounting board 100 may include a board main body 101, a first upper electrode 1011, a second upper electrode 1012, a first lower electrode 1021, a second lower electrode 1022, a first via electrode 1031 connecting the first upper electrode 1011 and the first lower electrode 1021 and a second via electrode 1032 connecting the second upper electrode 1012 and the second lower electrode 1022. The main body 101 of the mounting board 100 may be formed of insulating materials such as epoxy resin, glass fiber or the like, and the first and second upper electrodes 1011 and 1012, the first and second lower electrodes 1021 and 1022 and the first and second via electrodes 1031 and 1032 may be a metal layer formed of a metal such as Au, Cu, Ag, or Al. For example, the mounting board 100 may be provided as a FR4 copper clad laminate (CCL) board.

Referring to FIGs. 2 and 3, the first and second electrodes 37 and 38 of the LED chip 200 may be electrically connected to the mounting board 100 through the first and second upper electrodes 1011 and 1012 and first and second solder bumps 2011 and 2012, respectively.

Referring to FIGs. 1 and 3, the first and second leadframes 3001 and 3002 of the overmolded leadframe 300 are soldered or attached to the first and second lower electrodes 1021 and 1022 formed on the bottom surface of the mounting board 100, respectively. Thus, the LED chip 200 mounted on the mounting board 100 is electrically connected to the overmolded leadframe 300 through a conductive path formed of the first and second solder bumps 2011 and 2012, the first and second upper electrodes 1011 and 1012 formed on the upper surface of the mounting board 100, the first and second via electrodes 1031 and 1032 formed in the mounting board 100 and the first and second lower electrodes 1021 and 1022 formed on the bottom surface of the mounting board 100.

According to an exemplary embodiment, the first and second leadframes 3001 and 3002 are attached to the first and second lower electrodes 1021 and 1022 of the mounting board 100 by conductive adhesive.

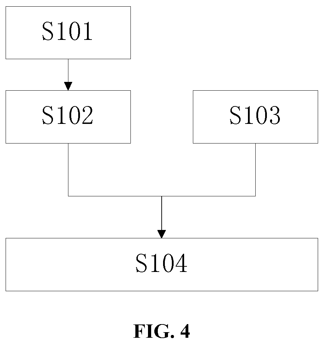

FIG. 4 is a view illustrating a method of manufacturing a LED device according to an exemplary embodiment of the inventive concept.

Referring to FIG. 4, the method of manufacturing a LED device according to an exemplary embodiment of the inventive concept may include preparing a mounting board (S101); mounting at least one LED chip on a top surface of the mounting board (S102); overmolding a leadframe to form an overmolded leadframe (S103); and soldering or attaching the mounting board having the at least one LED chip mounted thereon to the overmolded leadframe (S104). The at least one LED chip is electrically connected to the overmolded leadframe through via electrodes formed in the mounting board.

As shown in FIG. 4, the process of mounting LED chips (S101 and S102) and the process of overmolding leadframes (S103) are separated, and do not have a sequential relationship. The process of overmolding leadframes may be before or after the process of mounting LED chips. Alternatively, the process of mounting the LED chips and the process of overmolding the leadframes may be performed at substantially the same time.

According to the exemplary embodiment shown in FIG. 4, the process of mounting LED chips and the process of overmolding leadframes are separated, and can be performed in parallel, thus the LED chips are protected from being damaged during the process of overmolding, and the overall process for manufacturing the LED device is simplified.

According to an exemplary embodiment, in the step of S102, the at least one LED chip is mounted on the top surface of the mounting board in a flip-chip form. According to an exemplary embodiment, in the step of S104, the overmolded leadframe is attached to the mounting board having the at least one LED chip mounted thereon by conductive adhesive. Thus, the LED chips are protected from being damaged by not being exposed to high temperatures after completing the assembly on the top surface of the mounting board in a flip-chip form.

While exemplary embodiments have been shown and described above, it will be apparent to those skilled in the art that modifications and variations could be made without departing from the scope of the inventive concept as defined by the appended claims.

### LIST OF REFERENCE NUMERALS:

- 20: LED chip
- 21: light transmissive substrate
- 22: buffer layer
- 24: first conductivity-type semiconductor layer
- 25: active layer
- 26: second conductivity-type semiconductor layer
- 28a: first electrode
- 28b: second electrode
- 30: LED chip
- 31: light transmissive substrate
- 33: insulation portion
- 34: first conductivity-type semiconductor layer
- 35: active layer
- 36: second conductivity-type semiconductor layer
- 37: first electrode
- 37a: connection electrode portion of first electrode 37
- 37b: first electrode pad
- 38: second electrode
- 38a: ohmic contact layer of second electrode 38
- 38b: second electrode pad
- 40: LED chip
- 41: light transmissive substrate
- 42: insulating layer
- 43: filler portion
- 44: first conductivity-type semiconductor nanocore
- 45: active layer
- 46: second conductivity-type semiconductor layer
- 47: first electrode
- 48: second electrode
- 48a: ohmic contact layer of second electrode 48
- 48b: electrode pad
- 100: mounting board
- 101: board main body
- 200: LED chip
- 300: overmolded leadframe
- 1011: first upper electrode
- 1012: second upper electrode
- 1021: first lower electrode
- 1022: second lower electrode
- 1031: first via electrode
- 1032: second via electrode
- 2011: first solder bump
- 2012: second solder bump
- 3001: first leadframe
- 3002: second leadframe
- 3003: body
- B: base layer
- P: irregular pattern
- S: semiconductor stacked body
- S': light emitting nanostructures
- S101: method step of preparing a mounting board
- S102: method step of mounting at least one LED chip on a top surface of the mounting board
- S103: method step of overmolding a leadframe to form an overmolded leadframe
- S014: method step of soldering or attaching the mounting board having the at least one LED chip mounted thereon to the overmolded leadframe

## Claims

1. A LED device comprising:
a mounting board (100);
at least one LED chip (200) mounted on a top surface of the mounting board (100); and
an overmolded leadframe (300) soldered or attached to a bottom surface of the mounting board (100),
wherein the at least one LED chip (200) is electrically connected to the overmolded leadframe (300) through via electrodes (1031, 1032) formed in the mounting board (100).

2. The LED device of claim 1, wherein the at least one LED chip (200) is mounted in a flip-chip form.

3. The LED device of claim 1 or 2, wherein the overmolded leadframe (300) is attached to the mounting board (100) by conductive adhesive.

4. The LED device of claim 1 or 2, wherein a portion of the bottom surface of the mounting board (100) is covered with copper.

5. The LED device of claim 4, wherein the mounting board (100) is a FR4 copper clad laminate board.

6. The LED device of claim 1, wherein the at least one LED chip (200) is a Wafer Level Package.

7. A method of manufacturing a LED device comprising:
preparing a mounting board (100) with via electrodes (1031, 1032) formed therein;
mounting at least one LED chip (200) on a top surface of the mounting board (100);
overmolding a leadframe to form an overmolded leadframe (300); and
soldering or attaching the mounting board (100) having the at least one LED chip (200) mounted thereon to the overmolded leadframe (300),
wherein the at least one LED chip (200) is electrically connected to the overmolded leadframe (300) through the via electrodes (1031, 1032) formed in the mounting board (100).

8. The method of claim 7, wherein in the step of mounting at least one LED chip (200) on a top surface of the mounting board (100), the at least one LED chip (200) is mounted in a flip-chip form.

9. The method of claim 7 or 8, wherein in the step of soldering or attaching the mounting board (100) to the overmolded leadframe (300), the overmolded leadframe is attached to the mounting board by conductive adhesive.
